# DEMANDE DE BREVET EUROPEEN

(11) **EP 1 605 270 A1**
(43) Date de publication de la demande: **14.12.2005**
(21) Numéro de dépôt: 04300371.4
(22) Date de dépôt: 09.06.2004
(51) Int. Cl.: G01R 29/08

(54) **Antenne destinée à la mesure du rayonnement électromagnétique ambiant**

(71) Demandeur: FRANCE TELECOM, 75540 Paris Cedex 15 (FR); Antennessa, 29280 Plouzane (FR)
(72) Inventeur: Wiart, Joe, 77400 Lagny sur Marne (FR); Toutain, Yann, 29280 Locmaria Plouzane (FR); Lattard, Hervé, 29480, Le Relecq Kerhuon (FR); Perrot, Frédéric, 29860, Bourg Blanc (FR)
(74) Mandataire: Boire, Philippe Maxime Charles

(57) **Abrégé**

La présente invention concerne une antenne (100) destinée à la mesure de champs électromagnétiques ambiants, notamment afin de connaître l'exposition d'une personne à ces champs électromagnétiques, cette antenne comprenant au moins trois éléments (102, 104, 106) rayonnants à deux dimensions, agencés de telle sorte que l'ensemble de ces trois éléments (102, 104, 106) rayonnants discernent toutes les composantes spatiales d'un champ électromagnétique incident indépendamment de l'angle d'incidence des ondes associées à ces champs sur l'antenne (100).

## Description

La présente invention se rapporte à une antenne destinée à la mesure du rayonnement électromagnétique ambiant et à un dispositif de mesure du rayonnement électromagnétique ambiant muni d'une telle antenne.

Il est connu que l'exposition d'un individu à des champs électromagnétiques peut avoir un impact sanitaire sur cet individu lorsque la puissance de ces champs et/ou la durée d'exposition à ces champs atteignent des seuils donnés.

Dès lors, le développement intense des télécommunications, et notamment des réseaux de téléphonie mobile, engendre des préoccupations relatives aux niveaux d'expositions auxquels sont soumises les personnes présentes dans des zones couvertes par les antennes des services de télécommunications, et ce d'autant plus que ces personnes se situent à proximité des antennes requises pour ces télécommunications.

C'est pourquoi, il apparaît de plus en plus important de pouvoir déterminer le rayonnement électromagnétique auquel est soumis un individu tant sur une courte durée, par exemple lorsque cet individu est un technicien de télécommunication intervenant pendant cette courte durée à proximité d'une antenne, que sur une longue période, par exemple lorsque l'individu considéré réside dans un immeuble à proximité duquel est installée une antenne de télécommunications.

Cette importance est accrue en considérant les recommandations ou obligations législatives que certains pays mettent en oeuvre, par exemple sous la dénomination du « principe de précaution », visant à identifier les niveaux de risques sanitaires auxquels sont soumis des individus.

Actuellement, il est connu d'effectuer la mesure de l'exposition d'un individu au rayonnement électromagnétique ambiant à l'aide d'un type d'antenne mobile, ou sonde, telle que décrite par exemple dans la demande de brevet EP 1350285, publiée le 10 août 2003 et déposée au nom de France Télécom.

Bien qu'une telle antenne présente des performances intéressantes, elle s'avère inadaptée pour équiper un dispositif de mesure du rayonnement ambiant destiné à un large public.

De fait, une telle antenne présente l'inconvénient d'avoir des dimensions importantes qui rendent difficiles son utilisation pour des personnes se déplaçant au cours de la période de mesure.

Ces dimensions sont en parties imposées par des réflecteurs coniques à trois dimensions qui permettent notamment d'assurer une isotropie satisfaisante à l'antenne.

La prise en compte de ces réflecteurs et des éléments associés, tels que des composants diélectriques, provoque que l'antenne soit composée de nombreux éléments distincts, ce qui présente l'inconvénient de requérir des opérations de fabrication, et notamment d'assemblage, complexes et coûteuses.

Finalement, il convient de noter qu'un dernier inconvénient est dû au fait que certains éléments formant l'antenne ont un coût élevé, et notamment les cônes réflecteurs et des milieux diélectriques requis pour l'antenne.

La présente invention vise à remédier à au moins un de ces inconvénients en fournissant une antenne légère, de faibles dimensions et dont le coût de production est réduit.

Aussi, la présente invention concerne une antenne destinée à la mesure de champs électromagnétiques ambiants, notamment afin de connaître l'exposition d'une personne à ces champs électromagnétiques, cette antenne comprenant au moins trois éléments rayonnants à deux dimensions, agencés de telle sorte que l'ensemble de ces trois éléments rayonnants discernent toutes les composantes spatiales d'un champ électromagnétique incident indépendamment de l'angle d'incidence des ondes associées à ces champs sur l'antenne.

Grâce à l'invention, on dispose d'une antenne munie de trois éléments rayonnants, ce qui permet d'agencer ces derniers de façon à permettre la détection spatiale de toutes les composantes d'un champ électromagnétique incident sur l'antenne.

Il convient alors de noter que les trois éléments rayonnants discernent toutes les composantes spatiales d'un champ électromagnétique incident dans le cas où la source d'émission des ondes est déplacée par rapport à l'antenne et/ou dans le cas où l'antenne est déplacée par rapport à la source d'émission.

Finalement, en mettant en oeuvre des éléments rayonnants à deux dimensions, c'est-à-dire des éléments rayonnants pratiquement plans et pratiquement équivalents à des surfaces rayonnantes, l'invention permet de réduire la taille et le poids du dispositif.

Un autre avantage de l'invention est qu'une telle antenne peut être mise en oeuvre à l'aide d'un nombre limité de composants électroniques et/ou mécaniques simples, tels que de la tôle et des circuits imprimés, permettant ainsi à cette antenne d'être compacte et légère, et par conséquent aisément portable.

De ce fait, son utilisation individuelle, par exemple par des employés d'un opérateur de télécommunication et, d'une façon générale, par toute personne désirant connaître le niveau de rayonnement électromagnétique auquel il est soumis, est simple à mettre en oeuvre.

Selon une réalisation, les éléments rayonnants sont monopolaires ou dipolaires. L'utilisation d'éléments rayonnants monopolaires ou dipolaires permet d'assurer la mesure des champs électromagnétiques sur une large bande comprenant, notamment, les services de radiocommunication, de radiodiffusion, de radar, et d'une façon générale tout type de rayonnement non ionisant.

Dans une réalisation, au moins deux éléments rayonnants s'étendent sur un même plan.

Selon une réalisation, chaque élément rayonnant présentant un axe de symétrie, les trois éléments rayonnants sont disposés de telle sorte que les trois axes de symétrie forment un trièdre.

Dans une réalisation, chaque élément rayonnant présente un profil, c'est-à-dire une distance entre le périmètre de l'élément rayonnant et le bord en vis-à-vis de la masse associée cet élément rayonnant, variable le long du périmètre de l'élément rayonnant.

Selon une réalisation, les éléments rayonnants sont associés à un même circuit de traitement des signaux.

Dans une réalisation, le circuit de traitement comprend un commutateur permettant de traiter alternativement les signaux transmis par chaque élément rayonnant.

Selon une réalisation, un élément rayonnant est associé à une masse formée par un volume métallique symétrisant le volume de masse considéré par chaque élément rayonnant.

Dans une réalisation, le volume métallique comprend au moins un des éléments suivants : un commutateur, un amplificateur, un circuit d'adaptation, un convertisseur analogique numérique, un détecteur, un microcontrôleur, une source d'alimentation, des connecteurs, des absorbants ou des ferrites.

L'invention concerne aussi un dispositif destiné à la mesure de champs électromagnétiques ambiants, notamment afin de connaître l'exposition d'une personne à ces champs électromagnétiques, ce dispositif étant caractérisé en ce qu'il comprend une antenne selon l'une des réalisations précédentes.

Dans une réalisation, le dispositif comprend des moyens pour stocker des données relatives aux champs électromagnétiques détectés.

L'invention concerne également un système destiné à la mesure de champs électromagnétiques ambiants, notamment afin de connaître l'exposition d'une personne à ces champs électromagnétiques, ce système étant caractérisé en ce qu'il comprend des moyens pour recevoir des données transmises par un dispositif selon l'une des réalisations précédentes, notamment afin de comparer le niveau de rayonnement détecté par rapport à un seuil de rayonnement.

Dans une réalisation, le système comprend des moyens pour déterminer le niveau de rayonnement d'une ou de plusieurs bande(s) propres à un service utilisant une radioémission non ionisante.

Selon une réalisation, le système comprend des moyens pour considérer des services de télécommunications selon l'une des normes ou standard suivants : Global System for Mobile Communication (GSM), GSM 900, GSM 1800, Nordic Mobile Téléphone, Universal Mobile Télécommunication System (UMTS), l'Advanced Mobile Phone System (AMPS), Terrestrial Trunked Radio (Tetra), ou une norme ou standard de téléphonie sans fil telle que Wireless Local Area Network (WLAN) ou Wireless-Fidelity (WI-FI).

Finalement, l'invention concerne des données transmises par un dispositif selon l'une des réalisations précédentes ou des données traités dans un système selon l'une des réalisations précédentes.

D'autres caractéristiques et avantages de l'invention apparaîtront avec la description effectuée ci-dessous, à titre illustratif et non limitatif, d'un mode de réalisation préféré de l'invention à l'aide des figures ci-jointes sur lesquelles :

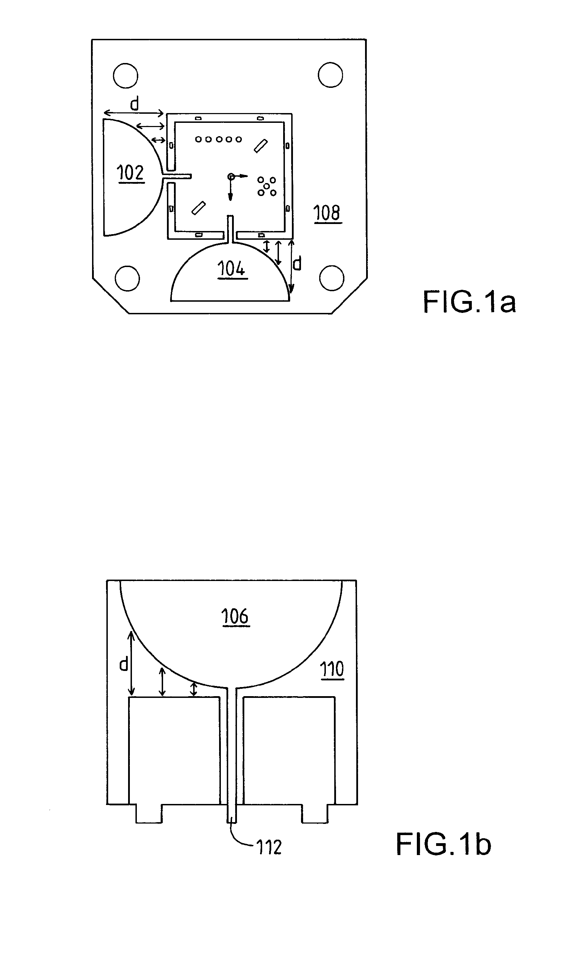

- les figures 1a et 1b sont des sous-éléments d'une antenne conforme à l'invention et

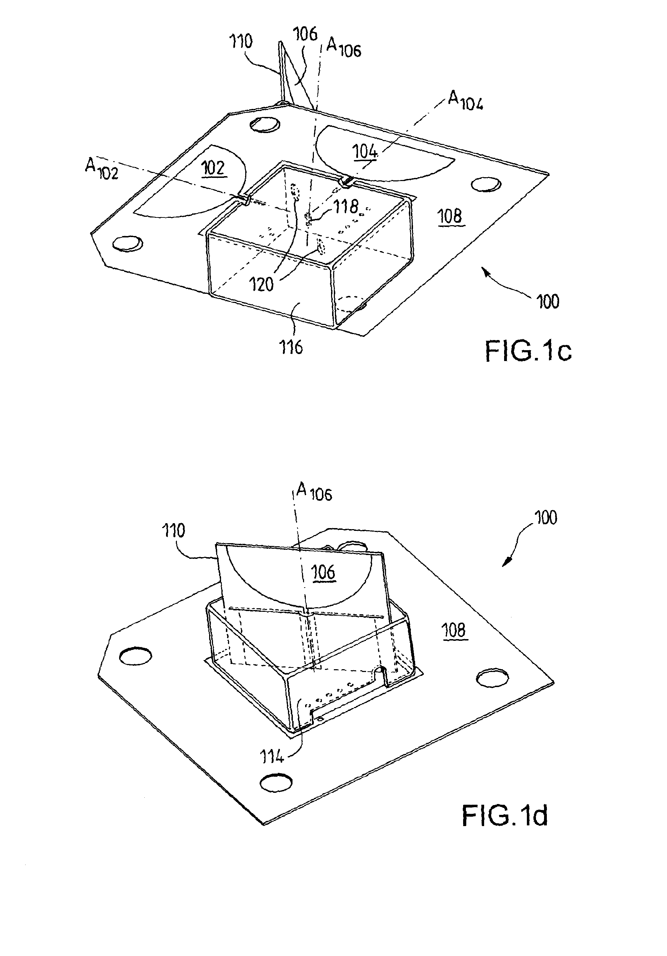

- les figures 1c et 1d sont des vues d'une antenne conforme à l'invention lorsque les sous-éléments sont agencés.

L'antenne décrite en détail ci-dessous est destinée à la mesure de champs électromagnétiques ambiants, notamment pour déterminer le niveau d'exposition d'une personne à ces champs électromagnétiques.

A cet effet, conformément à l'invention, elle comprend trois éléments rayonnants 102, 104 (figure 1b) et 106 (figure 1c) monopolaires à deux dimensions, c'est-à-dire que, en considérant les trois dimensions spatiales d'un élément, une de ces dimensions spatiales est pratiquement négligeable par rapport aux deux autres dimensions spatiales.

En d'autres termes, ces éléments rayonnants 102, 104 et 106 sont pratiquement plats et équivalents à des surfaces rayonnantes.

Ces trois éléments rayonnants 102, 104 et 106 étant à deux dimensions, la taille et le poids de l'antenne sont réduits, limitant également le coût de l'antenne.

Le coût de l'antenne, ou sonde, est également réduit par l'utilisation de technologies à faible coût relatives à la production de circuits imprimés ou au formage de tôle emboutie. De fait, l'antenne est composée notamment :
- d'un support conducteur 108, tel qu'un circuit imprimé, sur lequel sont gravés les deux éléments rayonnants 102 et 104 monopôles.
   En d'autres termes, les deux éléments rayonnants 102 et 104 s'étendent sur le plan formé par la surface du circuit imprimé 108.
- d'un support conducteur 110, tel qu'un circuit imprimé, sur lequel est gravé le troisième élément rayonnant 106 monopôle ainsi qu'une ligne 112 d'accès conductrice, par exemple du type triplaque, coplanaire et/ou coaxiale, permettant la connexion de l'élément rayonnant 106 avec le circuit imprimé 108 comme décrit ci-dessous à l'aide des figures 1c et 1d.

Sur la figure 1c est représentée une vue inférieure de l'agencement des circuits imprimés 108 et 110 tandis que sur la figure 1d est représenté le même agencement avec une vue supérieure complémentaire.

On observe alors que les circuits imprimés 108 et 110 sont agencés perpendiculairement l'un par rapport à l'autre de telle sorte que les éléments rayonnants 102, 104 et 106 puissent discerner toutes les composantes spatiales d'un champ électromagnétique incident sur l'antenne.

En d'autres termes, la projection d'une composante d'un tel champ magnétique est non nul sur au moins un des éléments rayonnant.

A cet effet, en considérant les axes de symétries Ai de chaque élément rayonnant i, les trois éléments rayonnants 102, 104 et 106 sont disposés de telle sorte que les trois axes de symétrie A102, A104 et A106 forment un trièdre, orthogonal dans cette réalisation de l'invention.

Sur les figures 1c et 1d, on observe également qu'une antenne conforme à ce mode de réalisation comprend :
- une tôle 114 supérieure pliée, à l'aide de tout type de procédé d'usinage et/ou de moulage, pour former un volume fermé, par exemple en forme de demi-cube;
- une tôle 116 inférieure également pliée, à l'aide de tout type de procédé d'usinage et/ou de moulage, pour former un volume fermé, par exemple en forme de demi-cube.

Sur la tôle 116 emboutie inférieure est gravée, usinée ou emboutie une fente 118 et deux trous 120 permettant respectivement le passage du circuit imprimé 110 et des lignes d'alimentation des deux monopôles 102 et 104 du circuit imprimé 108.

Cette tôle 116 emboutie inférieure comprend également un passage, non représenté, pour laisser passer un ou plusieurs câbles, notamment coaxiaux, permettant le contrôle des composants électroniques internes au volume défini par les tôles.

Ces composants électroniques internes peuvent comprendre un des éléments suivants : un commutateur, un amplificateur, un circuit d'adaptation permettant d'amener l'impédance de l'antenne à une valeur donnée, un convertisseur analogique numérique, un détecteur, un microcontrôleur, une source d'alimentation, des connecteurs, des absorbants tels que des ferrites.

Ainsi, en fonction des composants électroniques et/ou mécaniques sélectionnés, il est possible d'adapter les fonctions réalisées par l'antenne, et son coût.

Par ailleurs, il est possible d'utiliser les deux demi-cubes 114 et 116 en tôle font office de boîtier de blindage pour l'électronique intégrée.

En outre, ces boîtiers permettent de symétriser l'antenne alors même que les éléments rayonnants 102, 104 et 106 ne sont pas disposés symétriquement les uns par rapport aux autres.

La masse et la ligne d'alimentation de l'élément rayonnant 106 monopôle placé sur le circuit imprimé 110 sont soudés respectivement avec la masse et un brin chaud gravés sur le circuit imprimé 108.

Des trous de placement (non représentés) peuvent être réalisés sur un des circuits imprimés pour permettre la fixation de l'antenne sur un support ou dans un boîtier.

Il convient de noter que les éléments rayonnants 102, 104 et 106 présente un profil, c'est-à-dire une distance d entre le périmètre de l'élément rayonnant et le bord en vis-à-vis de la masse associée cet élément rayonnant, variable le long du périmètre de l'élément rayonnant pour élargir la bande de fonctionnement de l'élément rayonnant comme détaillé à l'aide des figures 1a et 1b.

Dans cette réalisation, cette variation est symétrique par rapport à l'axe Ai de symétrie présent dans chaque élément rayonnant afin de contribuer à l'isotropie de l'antenne.

Dans une application préférée, une antenne conforme à l'invention est intégrée dans un dispositif permettant de déterminer le niveau et l'origine du rayonnement électromagnétique auquel est soumis un individu en fonction d'un service donné de telle sorte que, si ce rayonnement s'avère excessif, des mesures nécessaires à la diminution de ce rayonnement peuvent être aisément envisagées.

L'invention peut être mise en oeuvre selon différentes variantes relatives à, notamment, la forme des pièces et le matériau utilisé pour ces pièces.

Par ailleurs, il est important de noter qu'un dispositif conforme à l'invention, c'est-à-dire un dispositif muni d'une antenne conforme à l'invention, peut être utilisé pour stocker les données relatives aux champs électromagnétiques détectés, un tel stockage étant simple à mettre en oeuvre à l'aide de moyens légers qui permettent d'assurer que le dispositif soit aisément portable.

Dans ce cas, un système conforme à l'invention peut comprendre des moyens pour recevoir des données transmises par un tel dispositif afin d'analyser ces dernières, par exemple pour comparer le niveau de rayonnement détecté par rapport à un seuil de rayonnement.

De façon à permettre une identification des champs détectés par le dispositif, un tel système peut comprendre des moyens pour déterminer le niveau de rayonnement d'une ou de plusieurs bande(s) de fréquences prédéterminés et propres à un service utilisant une radioémission non ionisante.

Par exemple, ces bandes de fréquences sont relatives à l'une des normes ou standard suivants : Global System for Mobile Communication (GSM), GSM 900, GSM 1800, Nordic Mobile Téléphone, Universal Mobile Télécommunication System (UMTS), l'Advanced Mobile Phone System (AMPS), Terrestrial Trunked Radio (Tetra), ou une norme ou standard de téléphonie sans fil telle que Wireless Local Area Network (WLAN) ou Wireless-Fidelity (WI-FI).

Ainsi, il apparaît que l'invention met en oeuvre des données, transmises par le dispositif au système de traitement, qui lui sont propres puisqu'elles indiquent des niveaux de rayonnement, sur une large bande de fréquence allant par exemple de 3 mHz à 8 Ghz, en identifiant les niveaux de rayonnement en fonction de services prédéterminés.

De telles opérations présentent un nombre illimité d'applications, mais il convient de souligner que les données générées à l'aide d'une antenne, d'un dispositif et/ou d'un système selon l'invention peuvent être utilisées notamment dans un cadre scientifique, par exemple une étude sur les niveaux d'exposition au rayonnement électromagnétique, professionnel, par exemple vis-à-vis de techniciens opérant à proximité d'antennes, public ou privé, pour une entreprise ou une collectivité telle qu'une organisation ou une association non gouvernementale.

De telles données peuvent donc aboutir à des cartographies de rayonnement, à des études statistiques et/ou à des bases de données protégées par cette demande de brevet.

## Revendications

1. Antenne (100) destinée à la mesure de champs électromagnétiques ambiants, notamment afin de connaître l'exposition d'une personne à ces champs électromagnétiques, cette antenne comprenant au moins trois éléments (102, 104, 106) rayonnants à deux dimensions, agencés de telle sorte que l'ensemble de ces trois éléments (102, 104, 106) rayonnants discernent toutes les composantes spatiales d'un champ électromagnétique incident indépendamment de l'angle d'incidence des ondes associées à ces champs sur l'antenne (100).

2. Antenne selon la revendication 1 **caractérisée en ce que** les éléments rayonnants sont monopolaires ou dipolaires.

3. Antenne selon la revendication 1 ou 2 **caractérisée en ce qu'**au moins deux éléments rayonnants (102, 104, 106) s'étendent sur un même plan.

4. Antenne selon la revendication 1, 2 ou 3 **caractérisée en ce que**, chaque élément rayonnant (102, 104, 106) présentant un axe de symétrie (A102, A104, A106), les trois éléments (102, 104, 106) rayonnants sont disposés de telle sorte que les trois axes (A102, A104, A106) de symétrie forment un trièdre.

5. Antenne selon la revendication 1, 2, 3 ou 4 **caractérisée en ce que** chaque élément rayonnant présente un profil, c'est-à-dire une distance (d) entre le périmètre de l'élément rayonnant et le bord en vis-à-vis de la masse associée cet élément rayonnant, variable le long du périmètre de l'élément rayonnant.

6. Antenne selon l'une des revendications précédentes **caractérisée en ce que** les éléments rayonnants sont associés à un même circuit de traitement des signaux.

7. Antenne selon la revendication 6 **caractérisé en ce que** le circuit de traitement comprend un commutateur permettant de traiter alternativement les signaux transmis par chaque élément rayonnant.

8. Antenne selon l'une des revendications précédentes **caractérisée en ce qu'**un élément rayonnant est associé à une masse formée par un élément métallique (114, 116) symétrisant le volume de masse considéré par chaque élément rayonnant.

9. Antenne selon la revendication 8 **caractérisé en ce que** le volume métallique comprend au moins un des éléments suivants : un commutateur, un amplificateur, un circuit d'adaptation, un convertisseur analogique numérique, un détecteur, un microcontrôleur, une source d'alimentation, des connecteurs, des absorbants ou des ferrites.

10. Dispositif destiné à la mesure de champs électromagnétiques ambiants, notamment afin de connaître l'exposition d'une personne à ces champs électromagnétiques, **caractérisée en ce qu'**il comprend une antenne selon l'une des revendications précédentes.

11. Dispositif selon la revendication 10 **caractérisé en ce qu'**il comprend des moyens pour stocker les données relatives aux champs électromagnétiques détectés.

12. Système destiné à la mesure de champs électromagnétiques ambiants, notamment afin de connaître l'exposition d'une personne à ces champs électromagnétiques, **caractérisée en ce qu'**il comprend des moyens pour recevoir des données transmises par un dispositif selon l'une des revendications 10 ou 11, notamment afin de comparer le niveau de rayonnement détecté par rapport à un seuil de rayonnement.

13. Système selon la revendication 12 **caractérisé en ce qu'**il comprend des moyens pour déterminer le niveau de rayonnement d'une ou de plusieurs bande(s) propres à un service utilisant une radioémission non ionisante.

14. Système selon l'une des revendications 12 ou 13 **caractérisé en ce qu'**il comprend des moyens pour considérer des services de télécommunications selon l'une des normes ou standard suivants : Global System for Mobile Communication (GSM), GSM 900, GSM 1800, Nordic Mobile Telephone, Universal Mobile Telecommunication System (UMTS), l'Advanced Mobile Phone System (AMPS), Terrestrial Trunked Radio (Tetra), ou une norme ou standard de téléphonie sans fil telle que Wireless Local Area Network (WLAN) ou Wireless-Fidelity (WI-FI).

15. Données transmises par un dispositif selon l'une des revendications 9 ou 10 en vue de leur traitement dans un système selon l'une des revendications 11, 12, 13 à 14.
